# EUROPÄISCHE PATENTSCHRIFT

(11) **EP 3 091 685 B1**
(45) Veröffentlichungstag und Bekanntmachung des Hinweises auf die Patenterteilung: **22.08.2018**
(21) Anmeldenummer: 16165209.4
(22) Anmeldetag: 14.04.2016
(51) Int. Cl.: H04L 1/24, G05B 19/042, G11C 5/06, G11C 29/00, G11C 7/10

(54) **VORRICHTUNG UND VERFAHREN ZUR VERARBEITUNG VON SERIELLEN DATENRAHMEN**
DEVICE AND METHOD FOR PROCESSING OF SERIAL DATA FRAMES
DISPOSITIF ET PROCEDE DESTINES A LA PREPARATION DE TRAMES DE DONNEES EN SERIE

(30) Priorität: 06.05.2015 DE 102015208409
(43) Veröffentlichungstag der Anmeldung: 09.11.2016
(73) Patentinhaber: Dr. Johannes Heidenhain GmbH, 83301 Traunreut (DE)
(72) Erfinder: von BERG, Martin, 83236 Übersee (DE)

(56) Entgegenhaltungen:
- EP-A1- 0 660 209
- US-A1- 2012 294 094
- US-A1- 2013 117 476

## Beschreibung

### GEBIET DER TECHNIK

Die vorliegende Erfindung betrifft eine Vorrichtung zur Verarbeitung von seriellen Datenrahmen nach Anspruch 1, sowie ein Verfahren zur Verarbeitung von seriellen Datenrahmen nach Anspruch 5. Weiter betrifft die Erfindung eine Datenübertragungsanordnung nach Anspruch 11.

### STAND DER TECHNIK

In der Automatisierungs- und Antriebstechnik werden hohe Anforderungen an die funktionale Sicherheit aller Komponenten gestellt. Das bedeutet, dass Fehlfunktionen schnell und zuverlässig erkannt werden müssen, um eine Gefahr für Bedienpersonal, das im Gefahrenbereich einer Anlage arbeitet, oder auch wirtschaftlichen Schaden durch Beschädigung von Maschinen oder Werkstücken, zu vermeiden.

Um ein hohes Maß an funktionaler Sicherheit zu erreichen, sind bereits viele Maßnahmen bekannt. So werden Messgeräte, insbesondere Positionsmessgeräte, häufig redundant ausgeführt, so dass zwei Messwerte zur Verfügung stehen, die weitgehend unabhängig voneinander generiert wurden. Für die Übertragung der Messwerte über eine digitale Datenschnittstelle werden diese mit Fehlererkennungsinformationen (z.B. Prüfsummen) versehen und in Form von Datenrahmen zur Folgeelektronik übertragen. Auf der Seite der Folgeelektronik wird dann die Plausibilität der Messwerte (Positionswerte) geprüft. Die Summe aller Maßnahmen bestimmt die Sicherheitsintegrität des Gesamtsystems.

Als digitale Datenschnittstellen werden in der Automatisierungs- und Antriebstechnik häufig serielle Schnittstellen eingesetzt. Das gilt besonders für elektrische Antriebe, bei denen im Betrieb laufend aktuelle Positionsistwerte von einer Positionsmesseinrichtung zu einer Folgeelektronik übertragen werden müssen, damit diese neue Positionssollwerte für die Regelkreise generieren kann, die einen Antriebsmotor steuern. Beispiele für serielle Schnittstellen in der Automatisierungstechnik sind in der EP 0 171 579 A1 und in der EP 0 660 209 A1 beschrieben. Typische Anwendungen für elektrische Antriebe sind Werkzeugmaschinen, Roboter oder auch Förderanlagen. Ein Beispiel für eine für die vorliegende Erfindung relevante Pufferschaltung ist in der US 2013/0117476 beschrieben. Grundprinzip serieller Schnittstellen ist es, Daten (Messwerte), die im Messgerät in paralleler Form vorliegen, in serielle Daten umzuwandeln, diese dann sequentiell innerhalb eines Datenrahmens über einen Datenübertragungskanal zur Folgeelektronik zu übertragen, wo sie wieder in parallele Daten zurückverwandelt werden. Seitens der Folgeelektronik werden die so erhaltenen parallelen Daten in Datenregistern zwischengespeichert und für die weitere Verwendung an eine Verarbeitungseinheit ausgegeben. Die Breite der Datenregister entspricht der Breite der empfangenen Daten.

Ein nur schwer erkennbares Fehlerbild ergibt sich, wenn durch einen Defekt das Speichern neuer Messwerte in ein Datenregister nicht mehr funktioniert und somit immer der gleiche Messwert an die Verarbeitungseinheit ausgegeben wird. Das ist besonders dann der Fall, wenn dieser Fehler in einem Zeitraum auftritt, in dem sich der Messwert über längere Zeit tatsächlich nicht ändert, beispielsweise wenn an einer Achse einer Werkzeugmaschine während eines Bearbeitungsvorgangs keine Positionsänderungen vorgenommen werden.

### ZUSAMMENFASSUNG DER ERFINDUNG

Es ist daher Aufgabe der Erfindung, eine Vorrichtung zu schaffen, die eine sichere Auswertung serieller Datenrahmen erlaubt.

Diese Aufgabe wird gelöst durch eine Vorrichtung nach Anspruch 1. Vorteilhafte Details einer derartigen Vorrichtung ergeben sich aus den von Anspruch 1 abhängigen Ansprüchen.

Es wird eine Vorrichtung zur Verarbeitung serieller Datenrahmen vorgeschlagen, umfassend eine Seriell-/Parallel-Wandlereinheit, eine Auswerteeinheit und wenigstens zwei Datenregister, wobei
- der Seriell-/Parallel-Wandlereinheit serielle Datenrahmen zugeführt sind und von der Seriell-/Parallel-Wandlereinheit serielle Datenblöcke, die in den seriellen Datenrahmen enthalten sind, in parallele Datenblöcke wandelbar und an die Datenregister ausgebbar sind,
- die parallelen Datenblöcke in den Datenregistern speicherbar und von diesen zur weiteren Verarbeitung an eine Verarbeitungseinheit ausgebbar sind und
- der Auswerteeinheit ebenfalls die seriellen Datenrahmen zugeführt sind und von der Auswerteeinheit das Speichern der parallelen Datenblöcke in die Datenregister abhängig von Inhalten der seriellen Datenrahmen steuerbar ist.

Die erfindungsgemäße Vorrichtung ist dadurch gekennzeichnet, dass zum Speichern von n zusammengehörenden Datenblöcken n Datenregister vorgesehen sind und von der Auswerteeinheit die Zuordnung der zusammengehörenden n Datenblöcke zu den n Datenregistern, in die sie gespeichert werden, veränderbar ist, wobei n eine natürliche Zahl größer oder gleich zwei ist.

Weiter ist es Aufgabe der Erfindung, ein Verfahren zu schaffen, das eine sichere Auswertung serieller Datenrahmen erlaubt.

Diese Aufgabe wird gelöst durch ein Verfahren nach Anspruch 5. Vorteilhafte Details des Verfahrens ergeben sich aus den von Anspruch 5 abhängigen Ansprüchen.

Es wird nun ein Verfahren zur Verarbeitung serieller Datenrahmen mittels einer Vorrichtung, die eine Seriell-/Parallel-Wandlereinheit, eine Auswerteeinheit und wenigstens zwei Datenregister umfasst, vorgeschlagen, wobei
- der Seriell-/Parallel-Wandlereinheit serielle Datenrahmen zugeführt werden und die Seriell-/Parallel-Wandlereinheit serielle Datenblöcke, die in den seriellen Datenrahmen enthalten sind, in parallele Datenblöcke wandelt und an die Datenregister ausgibt,
- die parallelen Datenblöcke in den Datenregistern gespeichert und von diesen zur weiteren Verarbeitung an eine Verarbeitungseinheit ausgegeben werden und
- der Auswerteeinheit ebenfalls die seriellen Datenrahmen zugeführt werden und die Auswerteeinheit das Speichern der parallelen Datenblöcke in die Datenregister abhängig von Inhalten der seriellen Datenrahmen steuert.

Die erfindungsgemäße Vorrichtung ist dadurch gekennzeichnet, dass zum Speichern von n zusammengehörenden Datenblöcken n Datenregister vorgesehen sind und von der Auswerteeinheit die Zuordnung der zusammengehörenden n Datenblöcke zu den n Datenregistern, in die sie gespeichert werden, verändert wird, wobei n eine natürliche Zahl größer oder gleich zwei ist.

Besonders vorteilhaft ist es, wenn die Auswerteeinheit die Zuordnung der zusammengehörenden Datenblöcke zu den Datenregistern zyklisch verändert, da dies die weitere Verarbeitung in der Verarbeitungseinheit vereinfacht.

Darüber hinaus ist es vorteilhaft, wenn die zusammengehörenden Datenblöcke in hintereinander bei der Vorrichtung eintreffen Datenrahmen enthalten sind, weil sich dadurch eine noch geringere Restfehlerwahrscheinlichkeit gegenüber der Übertragung innerhalb eines Datenrahmens ergibt. Außerdem ist in diesem Fall das Datenvolumen je Datenrahmen reduziert.

Weitere Vorteile sowie Einzelheiten der vorliegenden Erfindung ergeben sich aus der nachfolgenden Beschreibung anhand der Figuren.

### KURZE BESCHREIBUNG DER ZEICHNUNGEN

Es zeigt
- Figur 1: ein Blockschaltbild einer Datenübertragungsanordnung,
- Figur 2: ein Blockschaltbild einer erfindungsgemäßen Vorrichtung
- Figur 3: eine vereinfachte Darstellung eines erfindungsgemäßen Verfahrens,
- Figur 4: ein Blockschaltbild einerweiteren erfindungsgemäßen Vorrichtung,
- Figur 5: eine vereinfachte Darstellung eines weiteren erfindungsgemäßen Verfahrens und
- Figur 6: einen vorteilhaften Aufbau von zweiten Datenblöcken zu Figur 5.

### BESCHREIBUNG DER AUSFÜHRUNGSFORMEN

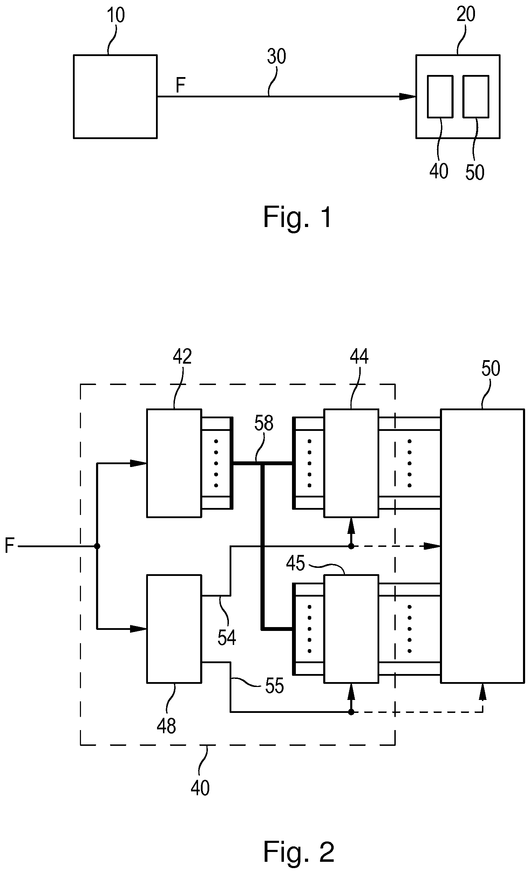

Figur 1 zeigt eine Datenübertragungsanordnung, geeignet zum Einsatz einer erfindungsgemäßen Vorrichtung zur Verarbeitung von seriellen Datenrahmen. Sie umfasst eine Positionsmesseinrichtung 10 und eine Folgeelektronik 20, die über einen Datenübertragungskanal 30 verbunden sind, der geeignet ausgestaltet ist, um serielle Datenrahmen F von der Positionsmesseinrichtung 10 zur Folgeelektronik 20 zu übertragen. In der Folgeelektronik 20 ist eine erfindungsgemäße Vorrichtung zur Verarbeitung von seriellen Datenrahmen 40 angeordnet, deren Aufbau und Funktion anhand der folgenden Figuren beschrieben wird. Weiter ist in der Folgeelektronik 20 eine Verarbeitungseinheit 50 angeordnet, der von der Vorrichtung 40 parallele Datenblöcke zur weiteren Verarbeitung zugeführt werden.

Auf welche Weise die seriellen Datenrahmen F über den Datenübertragungskanal 30 übertragen werden, ist für die vorliegende Erfindung nicht relevant. So kann die Übertragung beispielsweise drahtgebunden, über Lichtwellenleiter, etc. erfolgen. Dementsprechend sind dem Datenübertragungskanal 30 geeignete Signalsender/ -empfänger und ggf. Signalwandler zuzuordnen. Bei drahtgebundener Übertragung kommt mit Vorteil eine differentielle Signalübertragung zum Einsatz, beispielsweise nach dem in der Automatisierungstechnik weit verbreiteten RS-485-Standard. Das Kabel, das für die Signalübertragung eingesetzt wird, umfasst in diesem Fall ein oder mehrere miteinander verdrillte Leitungspaare. Weiter kann der Datenübertragungskanal 30 unidirektional (von der Positionsmesseinrichtung 10 zur Folgeelektronik 20) oder bidirektional ausgestaltet sein, wobei letzteres besonders vorteilhaft ist, weil bidirektionale Datenübertragung es ermöglicht, Befehle (und ggf. Daten) von der Folgeelektronik 20 zur Positionsmesseinrichtung 10 zu senden, um beispielsweise neben Messwerten (insbesondere Positionswerten) noch weitere Daten anzufordern, bzw. die Positionsmesseinrichtung 10 zu programmieren, kalibrieren, etc.

In der Praxis handelt es sich bei der Folgeelektronik 20 beispielsweise um eine Antriebssteuerung, insbesondere um eine numerische Steuerung zum Steuern einer Werkzeugmaschine. Da die Positionswerte die Basis für jeden Positionierungsvorgang bilden, ist es besonders wichtig, sie in der Positionsmesseinrichtung 10 sicher zu bilden und dann sicher zur Verarbeitungseinheit 50 zu übertragen.

Figur 2 zeigt nun ein Blockdiagramm einer erfindungsgemäßen Vorrichtung zur Verarbeitung von seriellen Datenrahmen 40. Sie umfasst eine Seriell-/Parallel-Wandlereinheit 42, zwei Datenregister 44, 45 und eine Auswerteeinheit 48.

Die Datenregister 44, 45 sind Speicherbausteine, die Datenworte bestimmter Breite, die ihnen an Dateneingängen zugeführt werden, speichern und die gespeicherten Datenworte über Datenausgänge wieder ausgeben können. Sie bestehen üblicherweise aus einer Anzahl von parallelgeschalteten Flip-Flops (z.B. D-Flip-Flops), bei denen das Speichern und Ausgeben von Daten über gemeinsame Steuerleitungen steuerbar ist.

Der Seriell-/Parallel-Wandlereinheit 42 werden, beispielsweise von der Positionsmesseinrichtung 10, serielle Datenrahmen F zugeführt. Sie wandelt serielle Datenblöcke, die in den Datenrahmen F enthalten sind, in parallele Datenblöcke und gibt diese an die Datenregister 44, 45 aus. Ein Datenrahmen F kann dabei mehrere serielle Datenblöcke umfassen. Die Eingänge der Datenregister 44, 45 sind mit den Ausgängen des Seriell-/Parallel-Wandlereinheit 42 über einen Datenbus 58 verbunden.

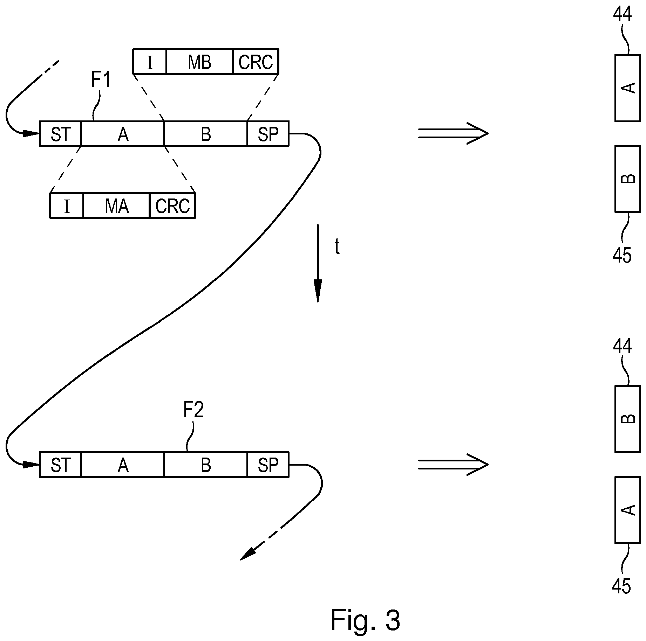

Der Auswerteeinheit 48 sind ebenfalls die seriellen Datenrahmen F zugeführt. Sie wertet sie dahingehend aus, dass sie ermittelt, zu welchen Zeitpunkten eintreffende Datenblöcke vollständig empfangen wurden und gibt Steuersignale 54, 55 an die Datenregister 44, 45 aus, um den jeweils aktuell an den Ausgängen des Seriell-/Parallel-Wandlereinheit 42 vorhandenen parallelen Datenblock in eines der Datenregister 44, 45 zu speichern. Wie nachfolgend anhand der Figur 3 gezeigt werden wird, ist die Zuordnung von zusammengehörenden Datenblöcken zu den Datenregistern 44, 45 veränderbar. Zusammengehörende serielle Datenblöcke sind im Rahmen der vorliegenden Erfindung Datenblöcke, die zusammen die Information über einen zu übertragenden Wert, insbesondere einen Messwert enthalten.

Die Datenregister 44, 45 geben wiederum die gespeicherten parallelen Datenblöcke (entweder unmittelbar, oder initiiert durch entsprechende Steuersignale (nicht dargestellt) der Verarbeitungseinheit 50) zur weiteren Verarbeitung an die Verarbeitungseinheit 50 aus. Um der Verarbeitungseinheit 50 zu signalisieren, dass in einem der Datenregister 44, 45 ein neuer paralleler Datenblock zur Verfügung steht, können beispielsweise die Steuersignale 54, 55 auch der Verarbeitungseinheit 50 zugeführt sein.

Abweichend zur in Figur 2 gewählten Ausführung können die Ausgänge der Datenregister 44, 45 ebenfalls parallel geschaltet sein. In diesem Fall können von der Verarbeitungseinheit 50 entsprechende Steuersignale generiert und den Datenregistern 44, 45 zugeführt werden, die die Ausgabe jeweils eines in einem der Datenregister 44, 45 gespeicherten Datenblocks A, B zur Verarbeitungseinheit 50 veranlassen. Handelsübliche Bausteine, die als Datenregister 44, 45 verwendbar sind, verfügen zu diesem Zweck über geeignete Steuereingänge, beispielsweise als "Output Enable" (OE) bezeichnet. Das Auslesen, bzw. die Übertragung der gespeicherten Datenblöcke A, B erfolgt in diesem Fall somit sequentiell und nicht, wie in Figur 2 dargestellt, parallel.

Figur 3 zeigt eine vereinfachte Darstellung eines erfindungsgemäßen Verfahrens, das mit einer Vorrichtung zur Verarbeitung serieller Datenrahmen, wie anhand der Figur 2 beschrieben, ausgeführt werden kann. Auf der linken Seite sind zwei serielle Datenrahmen F1, F2 dargestellt, die hintereinander bei der Vorrichtung 40 eintreffen. Die Datenrahmen F1, F2 umfassen jeweils zwei zusammengehörende serielle Datenblöcke A, B. Im Fall einer Datenübertragungsanordnung, wie sie in Figur 1 dargestellt ist, stammen die Datenrahmen F1, F2 von einer Positionsmesseinrichtung 10 und die seriellen Datenblöcke A, B enthalten die Information zur Bildung eines Positionswerts. Wird, in einem besonders einfachen Beispiel, von der Positionsmesseinrichtung 10 mit den Datenrahmen F1, F2 je ein Positionswert mit einer Breite von 32 Bit übertragen, so kann der serielle Datenblock A ausschließlich die niederwertigeren 16 Bit und der serielle Datenblock B ausschließlich die höherwertigen 16 Bit des Positionswerts umfassen. Aus diesen Teilmesswerten kann in der Verarbeitungseinheit 50 wieder der Gesamtmesswert, also in diesem Fall der Positionswert gebildet werden.

Erfindungsgemäß ist nun von der Auswerteeinheit 48 die Zuordnung der zusammengehörenden Datenblöcke A, B zu den Datenregistern 44, 45, in die sie gespeichert werden, veränderbar, wobei die Änderung der Zuordnung mit Vorteil zyklisch erfolgt. Im vorliegenden Beispiel bedeutet das, dass der Datenblock A aus dem ersten Datenrahmen F1 im ersten Datenregister 44 und der Datenblock B aus dem ersten Datenrahmen F1 im zweiten Datenregister 45 gespeichert werden, wohingegen der Datenblock A aus dem darauffolgenden zweiten Datenrahmen F2 im zweiten Datenregister 45 und der Datenblock B im ersten Datenregister 44 gespeichert werden. Bei einem darauffolgenden Datenrahmen würde die Zuordnung wieder umgekehrt. Da die Reihenfolge der Datenblöcke A, B in den Datenrahmen F1, F2 immer gleich ist, kann die Verarbeitungseinheit 50 durch Auswertung der Steuersignale 54, 55 ermitteln, in welchem Datenregister 44, 45 welcher Datenblock gespeichert wird. Alternativ kann die aktuelle Zuordnung der Datenblöcke A, B zu den Datenregistern 44, 45 der Verarbeitungseinheit 50 von der Auswerteeinheit 48 über separate Steuersignale (nicht dargestellt) mitgeteilt werden.

Im vorliegenden Beispiel sind für zwei zusammengehörende Datenblöcke A, B zwei Datenregister 44, 45 vorgesehen. Allgemein betrachtet muss die Anzahl der zusammengehörenden Datenblöcke gleich der Anzahl der Datenregister sein. Wird also mit den Datenrahmen F eine Anzahl von n zusammengehörenden Datenblöcken übertragen, so ist eine Anzahl von n Datenregistern vorzusehen, wobei n eine natürliche Zahl größer oder gleich zwei ist.

Durch die zyklische Änderung der Zuordnung der zusammengehörenden Datenblöcke A, B zu den Datenregistern 44, 45 wird der eingangs beschriebene Fehlerfall, dass durch einen Defekt eines Datenregisters 44, 45 der darin gespeicherte Datenblock A, B nicht mehr veränderbar ist, mit hoher Wahrscheinlichkeit aufgedeckt. Lediglich im Fall, dass die Datenblöcke A, B gleiche Inhalte haben, ist dieses Verfahren nicht wirksam. Um auch diesen Fall abzudecken, umfassen die Datenblöcke A, B mit Vorteil nicht ausschließlich die reinen Teilmesswerte MA, MB (im aktuellen Beispiel jeweils 16 Bit des Gesamtmesswerts), sondern auch eine Inhaltsinformation I, die angibt, welchen Teilmesswert MA, MB der jeweilige Datenblock A, B enthält. Auf diese Weise wird gewährleistet, dass sich die Datenblöcke A, B immer unterscheiden. Außerdem ist dadurch die Zuordnung Datenblock (Teilmesswert) - Datenregister für die Verarbeitungseinheit 50 eindeutig bestimmt und zusätzliche Steuersignale von der Auswerteeinheit 48 an die Verarbeitungseinheit 50 können entfallen.

Darüber hinaus ist es vorteilhaft, jedem Datenblock A, B eine Datensicherungsinformation CRC, beispielsweise eine Prüfsumme, einzufügen, durch deren Auswertung die Verarbeitungseinheit 50 erkennen kann, ob die Übertragung der Datenblöcke A, B fehlerfrei war.

Neben den zusammengehörenden Datenblöcken A, B können die Datenrahmen F1, F2 noch weitere Komponenten umfassen, insbesondere eine Startsequenz ST, um der Seriell-/Parallel-Wandlereinheit 42 den Beginn eines Datenrahmens F1, F2 anzuzeigen, sowie eine Endsequenz SP, die das Ende eines Datenrahmens F1, F2 signalisiert. Bei der Startsequenz ST und der Endsequenz SP kann es sich jeweils um ein einzelnes Bit (Startbit/Stoppbit), oder eine Kombination mehrerer Bits handeln, die Endsequenz kann weitere Datensicherungsinformationen umfassen.

Darüber hinaus können die Datenrahmen F1, F2 zusätzlich zu den zusammengehörenden Datenblöcken A, B noch weitere Datenblöcke enthalten, die auf herkömmliche Weise in weitere Datenregister gespeichert und an die Verarbeitungseinheit 50 ausgegeben werden.

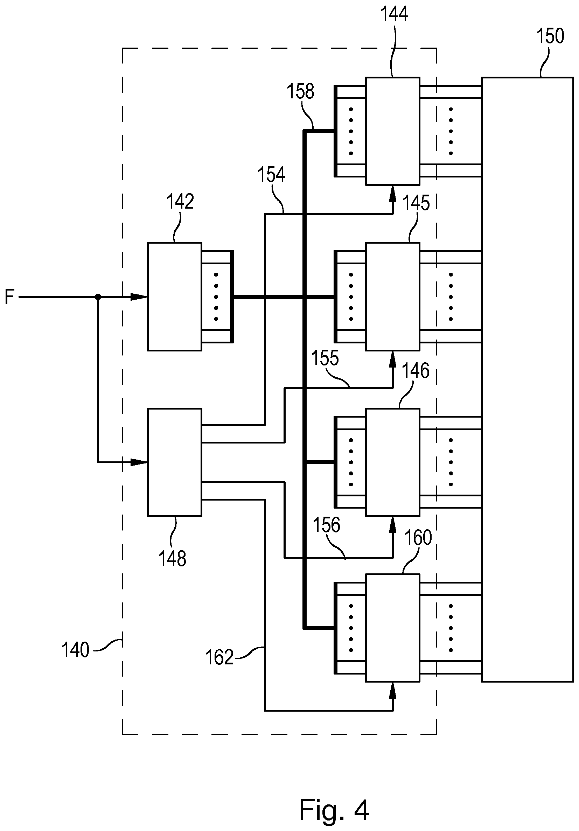

Figur 4 zeigt ein Blockdiagramm einer weiteren erfindungsgemäßen Vorrichtung zur Verarbeitung von seriellen Datenrahmen 140. Sie umfasst eine Seriell-/Parallel-Wandlereinheit 142, drei Datenregister 144, 145, 146 zum Speichern von zusammengehörenden Datenblöcken, ein weiteres Datenregister 160, sowie eine Auswerteeinheit 148.

Die Seriell-/Parallel-Wandlereinheit 142 hat die gleiche Funktion wie die Seriell-/Parallel-Wandlereinheit 42 aus Figur 2. Die Ausgänge der Seriell-/Parallel-Wandlereinheit 142 sind wiederum mit den Eingängen der Datenregister 144, 145, 146, 160 über einen Datenbus 158 verbunden.

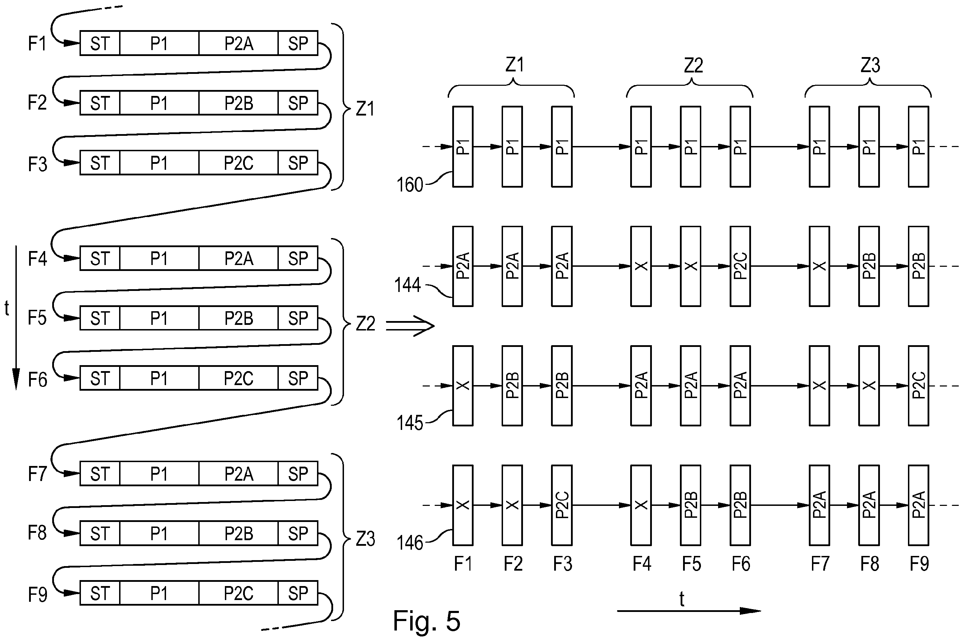

Das weitere Datenregister 160 dient zum Speichern von weiteren Datenblöcken, die nicht sicherheitsrelevant sind, oder, wie unten anhand der Figur 5 gezeigt werden wird, deren Inhalt durch die Inhalte der zusammengehörenden Datenblöcke überprüfbar ist.

Die Auswerteeinheit 148 wertet die eintreffenden Datenrahmen F aus und erzeugt zum Speichern der zusammengehörenden Datenblöcke und der weiteren Datenblöcke entsprechende Steuersignale 154, 155, 156, 162. Damit entspricht sie in ihrer Funktion weitgehend der Auswerteeinheit 48 aus dem vorhergehenden Ausführungsbeispiel. Abweichend zum vorhergehenden Ausführungsbeispiel ist, dass die zusammengehörenden Datenblöcke nicht innerhalb eines Datenrahmens empfangen werden, sondern in mehreren hintereinander eintreffen Datenrahmen enthalten sind. Dennoch ist die Zuordnung der zusammengehörenden Datenblöcke zu den Datenregistern 144, 145, 146 gemäß der vorliegenden Erfindung veränderbar, wobei auch hier die Änderung der Zuordnung mit Vorteil zyklisch erfolgt.

Die Übertragung der in den Datenregistern 144, 145, 146, 160 gespeicherten Datenblöcke zu einer Verarbeitungseinheit 150 kann wie dargestellt parallel, oder, wie oben bereits beschrieben, sequentiell erfolgen.

Die Vorrichtung 140 und die Verarbeitungseinheit 150 können die korrespondierende Vorrichtung 40 und Verarbeitungseinheit 50 der Folgeelektronik 20 aus Figur 1 ersetzen.

Figur 5 zeigt nun eine vereinfachte Darstellung eines erfindungsgemäßen Verfahrens, das mit einer Vorrichtung zur Verarbeitung serieller Datenrahmen, wie anhand der Figur 4 beschrieben, ausgeführt werden kann.

Auf der linken Seite der Figur 5 sind neun serielle Datenrahmen F1-F9 dargestellt, die sequentiell bei der erfindungsgemäßen Vorrichtung 140 eintreffen. Die Datenrahmen F1-F9 umfassen jeweils eine Startsequenz ST und eine Endsequenz SP, die nicht weiter erläutert werden, sowie einen ersten Datenblock P1, der einen ersten Messwert (Positionswert) umfasst und einen zweiten Datenblock P2A, P2B, P2C, der einen Teilmesswert umfasst, wobei die zweiten Datenblöcke P2A, P2B, P2C jeweils dreier aufeinanderfolgender Datenrahmen F1-F9 die Information zur Bildung eines Gesamtmesswert umfassen. Drei aufeinanderfolgende Datenrahmen F1-F9 können somit zu je einem Übertragungszyklus Z1, Z2, Z3 zusammengefasst werden. Die zweiten Datenblöcke P2A, P2B, P2C sind zusammengehörende Datenblöcke gemäß der vorliegenden Erfindung, beim ersten Datenblock P1 handelt es sich um einen weiteren Datenblock.

Es sei darauf hingewiesen, dass es für die vorliegende Erfindung weder zwingend erforderlich ist, dass zusammengehörende zweite Datenblöcke P2A, P2B, P2C in unmittelbar aufeinanderfolgenden Datenrahmen übertragen werden, noch, dass Übertragungszyklen unmittelbar aufeinanderfolgen. Es können jeweils zwischen den dargestellten Datenrahmen F1-F9 weitere Datenrahmen mit abweichendem Inhalt übertragen werden. Für deren Verarbeitung können weitere Datenregister vorgesehen sein.

Kommt die Vorrichtung 140 in einer Datenübertragungsanordnung gemäß Figur 1 zum Einsatz, so umfasst der erste Datenblock P1 mit Vorteil einen ersten Positionswert und die zweiten Datenblöcke P2A, P2B, P2C Teilpositionswerte eines zweiten Positionswerts.

In der Praxis werden der erste und der zweite Positionswert in der Positionsmesseinrichtung 10 möglichst unabhängig voneinander gebildet, basieren aber auf der Messung der gleichen Längen- oder Winkelposition. Die beiden Positionswerte können identisch sein, können aber auch einen definierten mathematischen Zusammenhang zueinander aufweisen, beispielsweise einen Offset. Außerdem können sie eine verschiedene Auflösung aufweisen.

Auf der rechten Seite der Figur 5 ist dargestellt, wie die einzelnen Datenblöcke P1, P2A, P2B, P2C, die mit den seriellen Datenrahmen F1-F9 bei der erfindungsgemäßen Vorrichtung 140 eintreffen, in die Datenregister 144, 145, 146, 160 gespeichert werden.

Der erste Datenblock P1 mit dem ersten Messwert wird beim Eintreffen eines Datenrahmens F1-F9 unmittelbar in das Datenregister 160 gespeichert. Der Verarbeitungseinheit 150 steht dieser Wert somit sofort zur Verfügung.

Im ersten Übertragungszyklus Z1 wird der zweite Datenblock P2A des ersten Datenrahmens F1 in das erste Datenregister 144 gespeichert, der zweite Datenblock P2B des zweiten Datenrahmens F2 in das zweite Datenregister 145 und der zweite Datenblock P2C des dritten Datenrahmens F3 in das dritte Datenregister 146. Nach dem ersten Übertragungszyklus Z1 stehen der Verarbeitungseinheit 150 die also die Teilmesswerte für einen Gesamtmesswert zur Verfügung.

Das bedeutet auch, dass der Verarbeitungseinheit 150 am Ende eines Übertragungszyklus zwei unabhängig voneinander gebildete Positionswerte zur Verfügung stehen und durch Vergleich, ggf. unter Berücksichtigung des bekannten mathematischen Zusammenhangs oder der unterschiedlichen Auflösung, Rückschlüsse auf die korrekte Funktion der Positionsmesseinrichtung 10 und des Datenübertragungskanals 30 gezogen werden können. Dadurch, dass zumindest der zweite Positionswert mittels der erfindungsgemäßen Vorrichtung 140, bzw. unter Anwendung des erfindungsgemäßen Verfahrens ausgewertet und der Verarbeitungseinheit 150 zur Verfügung gestellt wird, ist das Ergebnis des Vergleichs der zwei Positionswerte besonders sicher.

Im zweiten Übertragungszyklus Z2 wird der zweite Datenblock P2A des vierten Datenrahmens F4 in das zweite Datenregister 145 gespeichert, der zweite Datenblock P2B des fünften Datenrahmens F5 in das dritte Datenregister 146 und der zweite Datenblock P2C des sechsten Datenrahmens F6 in das erste Datenregister 144. Damit stehen der Verarbeitungseinheit 150 nach dem zweiten Übertragungszyklus Z2 wieder die Teilmesswerte für einen Gesamtmesswert zur Verfügung allerdings bei veränderter Zuordnung der zusammengehörenden zweiten Datenblöcke P2A, P2B, P2C zu den Datenregistern 144, 145, 146.

Im dritten Übertragungszyklus Z3 wird diese Zuordnung wieder verändert, so dass in diesem Zyklus der zweite Datenblock P2A des siebten Datenrahmens F7 in das dritte Datenregister 146, der zweite Datenblock P2B des achten Datenrahmens F8 in das erste Datenregister 144 und der zweite Datenblock P2C des neunten Datenrahmens F9 in das zweite Datenregister 145 gespeichert wird.

Bei darauffolgenden Übertragungszyklen kann die Zuordnung der Datenregister 144, 145, 146 zu den zweiten Datenblöcken P2A, P2B, P2C der Übertragungszyklen Z1-Z3 wiederholt werden, so dass sich die Zuordnung der Datenregister 144, 145, 146 zu den zweiten Datenblöcken P2A, P2B, P2C zyklisch ändert.

Nach der Übertragung der Inhalte der Datenregister 144, 145, 146 zur Verarbeitungseinheit 150 können diese in den Datenregister 144, 145, 146 verbleiben, bis sie von neuen zweiten Datenblöcken P2A, P2B, P2C überschrieben werden. Die Datenregister 144, 145, 146 können aber auch auf einen definierten Wert gesetzt werden. Die Zeitbereiche, in denen die Datenregister 144, 145, 146 keine aktuellen zweite Datenblöcke P2A, P2B, P2C enthalten, sind mit dem Buchstaben X gekennzeichnet.

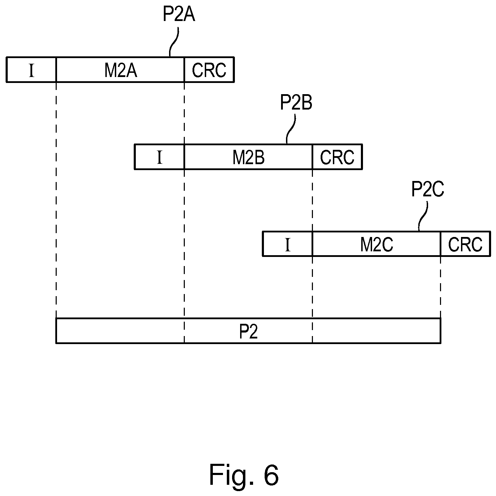

Ein vorteilhafter Aufbau der zweiten Datenblöcke P2A, P2B, P2C ist in Figur 6 dargestellt. Er entspricht im Wesentlichen dem vorteilhaften Aufbau der zusammengehörenden Datenblöcke A, B aus Figur 3. So umfasst jeder der zweiten Datenblöcke P2A, P2B, P2C neben einem Teilmesswert M2A, M2B, M2C eine Inhaltsinformation I, sowie optional eine Datensicherungsinformation CRC.

Jeder Teilmesswert M2A, M2B, M2C umfasst eine definierte Anzahl von Bits eines Gesamtmesswerts P2. Im vorliegenden Beispiel müssen drei Datenrahmen mit zusammengehörenden zweiten Datenblöcken P2A, P2B, P2C empfangen werden, um einen Gesamtmesswert P2 zu erhalten. Weist der Gesamtmesswert P2 also beispielsweise eine Datenbreite von 24 Bit auf, so umfasst jeder Teilmesswert M2A, M2B, M2C 8 Bits des Gesamtmesswerts P2.

Die Inhaltsinformation I gibt an, welcher Teilmesswert M2A, M2B, M2C im jeweiligen zweiten Datenblock P2A, P2B, P2C enthalten ist. Dies vereinfacht das Zusammenfügen des Gesamtmesswerts P2 in der Verarbeitungseinheit 150. Zusätzlich oder stattdessen können von der Auswerteeinheit 148 geeignete Steuersignale zur Verarbeitungseinheit 150 übertragen werden, die die Zuordnung der zweiten Datenblöcke P2A, P2B, P2C zu den Datenregistern 144, 145, 146 signalisieren. Ebenso kann ein Steuersignal vorgesehen sein, mit dem die Auswerteeinheit 148 der Verarbeitungseinheit 150 das Ende eines Übertragungszyklus Z1, Z2, Z3 anzeigt und damit signalisiert, dass aus den Inhalten der Datenregister 144, 145, 146 ein neuer zweiter Positionswert gebildet werden kann.

Die Datensicherungsinformation CRC ermöglicht der Verarbeitungseinheit 150 das Aufdecken von Übertragungsfehlern und stellt somit eine zusätzliche Maßnahme zur Erhöhung der Übertragungssicherheit dar.
Auch für dieses Ausführungsbeispiel gilt, dass allgemein betrachtet für eine Anzahl von n zusammengehörenden Datenblöcken, eine Anzahl von n Datenregistern vorzusehen ist, wobei n eine natürliche Zahl größer oder gleich zwei ist.

## Patentansprüche

1. Vorrichtung zur Verarbeitung serieller Datenrahmen, umfassend eine Seriell-/Parallel-Wandlereinheit (42, 142), eine Auswerteeinheit (48, 148) und wenigstens zwei Datenregister (44, 45, 144, 145, 146, 160), wobei
• der Seriell-/Parallel-Wandlereinheit (42, 142) serielle Datenrahmen (F, F1-F9) zugeführt sind und von der Seriell-/Parallel-Wandlereinheit (42, 142) serielle Datenblöcke (A, B, P1, P2A, P2B, P2C), die in den seriellen Datenrahmen (F, F1-F9) enthalten sind, in parallele Datenblöcke (A, B, P1, P2A, P2B, P2C) wandelbar und an die Datenregister (44, 45, 144, 145, 146, 160) ausgebbar sind,
• die parallelen Datenblöcke (A, B, P1, P2A, P2B, P2C) in den Datenregistern (44, 45, 144, 145, 146, 160) speicherbar und von diesen zur weiteren Verarbeitung an eine Verarbeitungseinheit (50, 150) ausgebbar sind und
• der Auswerteeinheit (48, 148) ebenfalls die seriellen Datenrahmen (F, F1-F9) zugeführt sind und von der Auswerteeinheit (48, 148) das Speichern der parallelen Datenblöcke (A, B, P1, P2A, P2B, P2C) in die Datenregister (44, 45, 144, 145, 146, 160) abhängig von Inhalten der seriellen Datenrahmen (F, F1-F9) steuerbar ist,
**dadurch gekennzeichnet, dass** zum Speichern von n zusammengehörenden Datenblöcken (A, B, P2A, P2B, P2C), die zusammen die Information über einen zu übertragenden Wert enthalten, n Datenregister (44, 45, 144, 145, 146) vorgesehen sind und von der Auswerteeinheit (48, 148) die Zuordnung der zusammengehörenden n Datenblöcke (A, B, P2A, P2B, P2C) zu den n Datenregistern (44, 45, 144, 145, 146), in die sie gespeichert werden, zyklisch veränderbar ist, wobei n eine natürliche Zahl größer oder gleich zwei ist.

2. Vorrichtung nach Anspruch 1, **dadurch gekennzeichnet, dass** die Ausgänge der Seriell-/Parallel-Wandlereinheit (42, 142) und die Dateneingänge der Datenregister (44, 45, 144, 145, 146, 160) über einen Datenbus (58, 158) miteinander verbunden sind.

3. Vorrichtung nach einem der vorhergehenden Ansprüche, **dadurch gekennzeichnet, dass** die zusammengehörenden Datenblöcke (A, B, P2A, P2B, P2C) in hintereinander bei der Vorrichtung eintreffen Datenrahmen (F, F1-F9) enthalten sind.

4. Verfahren zur Verarbeitung serieller Datenrahmen (F, F1-F9) mittels einer Vorrichtung, die eine Seriell-/Parallel-Wandlereinheit (42, 142), eine Auswerteeinheit (48, 148) und wenigstens zwei Datenregister (44, 45, 144, 145, 146, 160) umfasst, wobei
• der Seriell-/Parallel-Wandlereinheit (42, 142) serielle Datenrahmen (F, F1-F9) zugeführt werden und die Seriell-/Parallel-Wandlereinheit (42, 142) serielle Datenblöcke (A, B, P1, P2A, P2B, P2C), die in den seriellen Datenrahmen (F, F1-F9) enthalten sind, in parallele Datenblöcke (A, B, P1, P2A, P2B, P2C) wandelt und an die Datenregister (44, 45, 144, 145, 146, 160) ausgibt,
• die parallelen Datenblöcke (A, B, P1, P2A, P2B, P2C) in den Datenregistern (44, 45, 144, 145, 146, 160) gespeichert und von diesen zur weiteren Verarbeitung an eine Verarbeitungseinheit (50, 150) ausgegeben werden und
• der Auswerteeinheit (48, 148) ebenfalls die seriellen Datenrahmen (F, F1-F9) zugeführt werden und die Auswerteeinheit (48, 148) das Speichern der parallelen Datenblöcke (A, B, P1, P2A, P2B, P2C) in die Datenregister (44, 45, 144, 145, 146, 160) abhängig von Inhalten der seriellen Datenrahmen (F, F1-F9) steuert,
**dadurch gekennzeichnet, dass** zum Speichern von n zusammengehörenden Datenblöcken (A, B, P2A, P2B, P2C), die zusammen die Information über einen zu übertragenden Wert enthalten, n Datenregister (44, 45, 144, 145, 146) vorgesehen sind und von der Auswerteeinheit (48, 148) die Zuordnung der zusammengehörenden n Datenblöcke (A, B, P2A, P2B, P2C) zu den n Datenregistern (44, 45, 144, 145, 146), in die sie gespeichert werden, zyklisch verändert wird, wobei n eine natürliche Zahl größer oder gleich zwei ist.

5. Verfahren nach Anspruch 4, **dadurch gekennzeichnet, dass** die zusammengehörenden Datenblöcke (A, B, P2A, P2B, P2C) in hintereinander bei der Vorrichtung eintreffen Datenrahmen (F, F1-F9) enthalten sind.

6. Verfahren nach einem der Ansprüche 4 bis 5, **dadurch gekennzeichnet, dass** jeder der zusammengehörenden Datenblöcke (A, B, P2A, P2B, P2C) einen Teilmesswert (MA, MB, M2A, M2B, M2C) eines Gesamtmesswerts (P2) enthält.

7. Verfahren nach Anspruch 6, **dadurch gekennzeichnet, dass** jeder der zusammengehörenden Datenblöcke (A, B, P2A, P2B, P2C) eine Inhaltsinformation (I) umfasst, die angibt, welchen Teilmesswert (MA, MB, M2A, M2B, M2C) des Gesamtmesswerts (P2) der Datenblock (A, B, P2A, P2B, P2C) enthält.

8. Verfahren nach einem der Ansprüche 4 bis 7, **dadurch gekennzeichnet, dass** jeder der zusammengehörenden Datenblöcke (A, B, P2A, P2B, P2C) eine Datensicherungsinformation (CRC) umfasst.

9. Datenübertragungsanordnung mit einer Positionsmesseinrichtung (10), die über einen Datenübertragungskanal (30) mit einer Folgeelektronik (20) verbunden ist, wobei über den Datenübertragungskanal (30) serielle Datenrahmen (F, F1-F9) zur Folgeelektronik (20) übertragbar sind, **dadurch gekennzeichnet, dass** die Folgeelektronik (20) eine Vorrichtung nach einem der Ansprüche 1 bis 3 umfasst.

## Claims

1. Device for processing serial data frames, comprising a serial/parallel converter unit (42, 142), an evaluation unit (48, 148) and at least two data registers (44, 45, 144, 145, 146, 160), wherein
• serial data frames (F, F1-F9) are supplied to the serial/parallel converter unit (42, 142) and serial data blocks (A, B, P1, P2A, P2B, P2C) contained in the serial data frames (F, F1-F9) can be converted into parallel data blocks (A, B, P1, P2A, P2B, P2C) by the serial/parallel converter unit (42, 142) and can be output to the data registers (44, 45, 144, 145, 146, 160),
• the parallel data blocks (A, B, P1, P2A, P2B, P2C) can be stored in the data registers (44, 45, 144, 145, 146, 160) and can be output from the latter to a processing unit (50, 150) for further processing, and
• the serial data frames (F, F1-F9) are likewise supplied to the evaluation unit (48, 148) and the evaluation unit (48, 148) can control the storage of the parallel data blocks (A, B, P1, P2A, P2B, P2C) in the data registers (44, 45, 144, 145, 146, 160) on the basis of the contents of the serial data frames (F, F1-F9),
**characterized in that** n data registers (44, 45, 144, 145, 146) are provided for the purpose of storing n associated data blocks (A, B, P2A, P2B, P2C) which together contain the information relating to a value to be transmitted and the evaluation unit (48, 148) can cyclically change the assignment of the associated n data blocks (A, B, P2A, P2B, P2C) to the n data registers (44, 45, 144, 145, 146) in which they are stored, wherein n is a natural number greater than or equal to two.

2. Device according to Claim 1, **characterized in that** the outputs of the serial/parallel converter unit (42, 142) and the data inputs of the data registers (44, 45, 144, 145, 146, 160) are connected to one another via a data bus (58, 158).

3. Device according to one of the preceding claims, **characterized in that** the associated data blocks (A, B, P2A, P2B, P2C) are contained in data frames (F, F1-F9) arriving at the device in succession.

4. Method for processing serial data frames (F, F1-F9) by means of a device comprising a serial/parallel converter unit (42, 142), an evaluation unit (48, 148) and at least two data registers (44, 45, 144, 145, 146, 160), wherein
• serial data frames (F, F1-F9) are supplied to the serial/parallel converter unit (42, 142) and the serial/parallel converter unit (42, 142) converts serial data blocks (A, B, P1, P2A, P2B, P2C) contained in the serial data frames (F, F1-F9) into parallel data blocks (A, B, P1, P2A, P2B, P2C) and outputs them to the data registers (44, 45, 144, 145, 146, 160),
• the parallel data blocks (A, B, P1, P2A, P2B, P2C) are stored in the data registers (44, 45, 144, 145, 146, 160) and are output from the latter to a processing unit (50, 150) for further processing, and
• the serial data frames (F, F1-F9) are likewise supplied to the evaluation unit (48, 148) and the evaluation unit (48, 148) controls the storage of the parallel data blocks (A, B, P1, P2A, P2B, P2C) in the data registers (44, 45, 144, 145, 146, 160) on the basis of the contents of the serial data frames (F, F1-F9),
**characterized in that** n data registers (44, 45, 144, 145, 146) are provided for the purpose of storing n associated data blocks (A, B, P2A, P2B, P2C) which together contain the information relating to a value to be transmitted and the evaluation unit (48, 148) cyclically changes the assignment of the associated n data blocks (A, B, P2A, P2B, P2C) to the n data registers (44, 45, 144, 145, 146) in which they are stored, wherein n is a natural number greater than or equal to two.

5. Method according to Claim 4, **characterized in that** the associated data blocks (A, B, P2A, P2B, P2C) are contained in data frames (F, F1-F9) arriving at the device in succession.

6. Method according to one of Claims 4 to 5, **characterized in that** each of the associated data blocks (A, B, P2A, P2B, P2C) contains a partial measured value (MA, MB, M2A, M2B, M2C) of an overall measured value (P2).

7. Method according to Claim 6, **characterized in that** each of the associated data blocks (A, B, P2A, P2B, P2C) comprises an item of content information (I) which indicates which partial measured value (MA, MB, M2A, M2B, M2C) of the overall measured value (P2) the data block (A, B, P2A, P2B, P2C) contains.

8. Method according to one of Claims 4 to 7, **characterized in that** each of the associated data blocks (A, B, P2A, P2B, P2C) comprises an item of data backup information (CRC).

9. Data transmission arrangement having a position measuring device (10) which is connected to downstream electronics (20) via a data transmission channel (30), wherein serial data frames (F, F1-F9) can be transmitted to the downstream electronics (20) via the data transmission channel (30), **characterized in that** the downstream electronics (20) comprise a device according to one of Claims 1 to 3.

## Revendications

1. Dispositif de traitement de trames de données en série, comprenant une unité de conversion série/parallèle (42, 142), une unité d'interprétation (48, 148) et au moins deux registres de données (44, 45, 144, 145, 146, 160),
* des trames de données en série (F, F1-F9) étant acheminées à l'unité de conversion série/parallèle (42, 142) et des blocs de données en série (A, B, P1, P2A, P2B, P2C), qui sont contenus dans les trames de données en série (F, F1-F9), pouvant être convertis par l'unité de conversion série/parallèle (42, 142) en blocs de données en parallèle (A, B, P1, P2A, P2B, P2C) et pouvant être délivrés aux registres de données (44, 45, 144, 145, 146, 160),
* les blocs de données en parallèle (A, B, P1, P2A, P2B, P2C) pouvant être enregistrés dans les registres de données (44, 45, 144, 145, 146, 160) et pouvant être délivrés par ceux-ci à une unité de traitement (50, 150) en vue d'un traitement supplémentaire et
* les trames de données en série (F, F1-F9) étant également acheminées à l'unité d'interprétation (48, 148) et l'enregistrement des blocs de données en parallèle (A, B, P1, P2A, P2B, P2C) dans les registres de données (44, 45, 144, 145, 146, 160) pouvant être commandé par l'unité d'interprétation (48, 148) en fonction des contenus des trames de données en série (F, F1-F9),
**caractérisé en ce que** n registres de données (44, 45, 144, 145, 146) sont présents pour l'enregistrement de n blocs de données (A, B, P2A, P2B, P2C) associés qui contiennent ensemble l'information à propos d'une valeur à transmettre, et l'affectation des n blocs de données (A, B, P2A, P2B, P2C) associés aux n registres de données (44, 45, 144, 145, 146) dans lesquels ils sont enregistrés peut être modifiée cycliquement par l'unité d'interprétation (48, 148), n étant un nombre naturel égal ou supérieur à deux.

2. Dispositif selon la revendication 1, **caractérisé en ce que** les sorties de l'unité de conversion série/parallèle (42, 142) et les entrées de données des registres de données (44, 45, 144, 145, 146, 160) sont reliées ensemble par le biais d'un bus de données (58, 158).

3. Dispositif selon l'une des revendications précédentes, **caractérisé en ce que** les blocs de données (A, B, P2A, P2B, P2C) associés sont contenus dans des trames de données (F, F1-F9) qui arrivent les unes derrière les autres au niveau du dispositif.

4. Procédé de traitement de trames de données en série (F, F1-F9) au moyen d'un dispositif qui comporte une unité de conversion série/parallèle (42, 142), une unité d'interprétation (48, 148) et au moins deux registres de données (44, 45, 144, 145, 146, 160),
* des trames de données en série (F, F1-F9) étant acheminées à l'unité de conversion série/parallèle (42, 142) et des blocs de données en série (A, B, P1, P2A, P2B, P2C), qui sont contenus dans les trames de données en série (F, F1-F9), étant convertis par l'unité de conversion série/parallèle (42, 142) en blocs de données en parallèle (A, B, P1, P2A, P2B, P2C) et étant délivrés aux registres de données (44, 45, 144, 145, 146, 160),
* les blocs de données en parallèle (A, B, P1, P2A, P2B, P2C) étant enregistrés dans les registres de données (44, 45, 144, 145, 146, 160) et étant délivrés par ceux-ci à une unité de traitement (50, 150) en vue d'un traitement supplémentaire et
* les trames de données en série (F, F1-F9) étant également acheminées à l'unité d'interprétation (48, 148) et l'enregistrement des blocs de données en parallèle (A, B, P1, P2A, P2B, P2C) dans les registres de données (44, 45, 144, 145, 146, 160) étant commandé par l'unité d'interprétation (48, 148) en fonction des contenus des trames de données en série (F, F1-F9),
**caractérisé en ce que** n registres de données (44, 45, 144, 145, 146) sont présents pour l'enregistrement de n blocs de données (A, B, P2A, P2B, P2C) associés qui contiennent ensemble l'information à propos d'une valeur à transmettre, et l'affectation des n blocs de données (A, B, P2A, P2B, P2C) associés aux n registres de données (44, 45, 144, 145, 146) dans lesquels ils sont enregistrés est modifiée cycliquement par l'unité d'interprétation (48, 148), n étant un nombre naturel égal ou supérieur à deux.

5. Procédé selon la revendication 4, **caractérisé en ce que** les blocs de données (A, B, P2A, P2B, P2C) associés sont contenus dans des trames de données (F, F1-F9) qui arrivent les unes derrière les autres au niveau du dispositif.

6. Procédé selon l'une des revendications 4 à 5, **caractérisé en ce que** chacun des blocs de données (A, B, P2A, P2B, P2C) associés contient une valeur mesurée partielle (MA, MB, M2A, M2B, M2C) d'une valeur mesurée totale (P2).

7. Procédé selon la revendication 6, **caractérisé en ce que** chacun des blocs de données (A, B, P2A, P2B, P2C) associés contient une information de contenu (I) qui indique quelle valeur mesurée partielle (MA, MB, M2A, M2B, M2C) de la valeur mesurée totale (P2) contient le bloc de données (A, B, P2A, P2B, P2C).

8. Procédé selon l'une des revendications 4 à 7, **caractérisé en ce que** chacun des blocs de données (A, B, P2A, P2B, P2C) associés comporte une information de sécurité des données (CRC).

9. Arrangement de transmission de données comprenant un dispositif de mesure de position (10) qui est relié à une électronique en aval (20) par le biais d'un canal de transmission de données (30), des trames de données en série (F, F1-F9) pouvant être transmises à l'électronique en aval (20) par le biais du canal de transmission de données (30), **caractérisé en ce que** l'électronique en aval (20) comporte un dispositif selon l'une des revendications 1 à 3.
